Europäisches Patentamt

European Patent Office

Office européen des brevets

(19)

(11) **EP 1 107 015 B1**

(12) **EUROPÄISCHE PATENTSCHRIFT**

(45) Veröffentlichungstag und Bekanntmachung des Hinweises auf die Patenterteilung:
**14.06.2006 Patentblatt 2006/24**

(51) Int Cl.:
*G01R 33/567* (2006.01)

(21) Anmeldenummer: **00204118.4**

(22) Anmeldetag: **22.11.2000**

(54) **MR-Verfahren zur Erzeugung von Navigatorimpulsen**

MR-method for generating navigator pulses

Procédé de la résonance magnétique pour la génération d'impulsions navigatrices

(84) Benannte Vertragsstaaten:
**DE FR GB NL**

(30) Priorität: **01.12.1999 DE 19957754**

(43) Veröffentlichungstag der Anmeldung:
**13.06.2001 Patentblatt 2001/24**

(73) Patentinhaber:
• **Philips Intellectual Property & Standards GmbH**
**20099 Hamburg (DE)**
Benannte Vertragsstaaten:
**DE**
• **Koninklijke Philips Electronics N.V.**
**5621 BA Eindhoven (NL)**
Benannte Vertragsstaaten:
**FR GB NL**

(72) Erfinder:
• **Nehrke, Kay, Dr.**
**52064 Aachen (DE)**
• **Börnert, Peter, Dr.**
**52064 Aachen (DE)**

(74) Vertreter: **Volmer, Georg et al**
**Philips Intellectual Property & Standards GmbH,**
**Postfach 50 04 42**
**52088 Aachen (DE)**

(56) Entgegenhaltungen:
**EP-A- 0 498 570**

• **BUTTS K ET AL: "ISOTROPIC DIFFUSION-WEIGHTED AND SPIRAL-NAVIGATED INTERLEAVED EPI FOR ROUTINE IMAGING OF ACUTE STROKE" MAGNETIC RESONANCE IN MEDICINE, ACADEMIC PRESS, DULUTH, MN, US, Bd. 38, Nr. 5, 1997, Seiten 741-749, XP000861750 ISSN: 0740-3194**
• **SACHS T ET AL: "REAL-TIME MOTION DETECTION IN SPIRAL MRI USING NAVIGATORS" MAGNETIC RESONANCE IN MEDICINE, ACADEMIC PRESS, DULUTH, MN, US, Bd. 32, Nr. 5, 1. November 1994 (1994-11-01), Seiten 639-645, XP000479921 ISSN: 0740-3194**
• **NEHRKE K ET AL: "On the performance and accuracy of 2D navigator pulses" MAGNETIC RESONANCE IMAGING, OCT. 1999, ELSEVIER, USA, Bd. 17, Nr. 8, Seiten 1173-1181, XP002239984 ISSN: 0730-725X**

EP 1 107 015 B1

**Beschreibung**

Die Erfindung betrifft ein MR-Verfahren (MR= Magnetresonanz), bei dem mindestens ein Navigatorimpuls zur Anregung der Kernmagnetisierung in einem räumlich begrenzten Bereich mittels mindestens jeweils eines Hochfrequenzimpulses und wenigstens zweier Gradienten-Magnetfelder mit zeitlich und räumlich unterschiedlich verlaufenden Gradienten erzeugt wird, wonach mindestens ein MR-Signal aus dem Bereich in Verbindung mit einem weiteren Gradienten-Magnetfeld empfangen und ausgewertet wird. Außerdem bezieht sich die Erfindung auf ein MR-Gerät zur Durchführung dieses Verfahrens, sowie auf ein Computerprogramm für eine Steuereinheit eines MR-Gerätes zur Durchführung dieses Verfahrens.

Ein Verfahren dieser Art ist aus der europäischen Patentanmeldung EP-A 0793113 (PHD 96-022) sowie aus einem Aufsatz von Nehrke, Börnert et al in der Zeitschrift "Magnetic Resonance Imaging", Vol. 17, Nr. 8, pp 1173-1181, 1999 bekannt. Navigatorimpulse ermöglichen die Anregung eines in zwei Dimensionen beschränkten Bereichs, z.B. eines zylinderförmigen Stabes (pencil beam). Trifft ein solcher Navigatorimpuls beispielsweise auf das Zwerchfell eines Patienten, dann läßt sich dessen Bewegungszustand bzw. die Atmung des Patienten durch Auswertung der nach dem Navigatorimpuls empfangenen MR-Signale bestimmen. Diese Impulse können zur Detektion des Bewegungszustandes eines Untersuchungsobjektes verwendet werden, beispielsweise bei den sogenannten Gating-Techniken.

Da die Stärke des Gradienten beschränkt ist, kann während der endlichen Dauer des Navigatorimpulses im k-Raum nur ein Gebiet mit beschränkter Ausdehnung und mit endlicher Dichte durchquert werden. Dies führt zu einer Begrenzung der Auflösung sowie zur Anregung von unerwünschten Aliasing-Strukturen, die die Detektion des Bewegungszustandes erschweren können. Wenn man länger dauernde Navigatorimpulse benutzen würde, um einen größeren Bereich im k-Raum mit größerer Dichte abfahren zu können, würden sich sogenannte "off-resonance-Effekte" bemerkbar machen, beispielsweise als Folge der Inhomogenität des stationären Magnetfeldes, dem das Untersuchungsobjekt während einer MR-Untersuchung ausgesetzt ist. Diese Effekte führen dazu, daß der Bereich, der durch den Navigatorimpuls angeregt wird, sich ausweitet, was die Auswertung der MR-Signale ebenfalls erschwert.

Aufgabe der vorliegenden Erfindung ist es, ein Verfahren der eingangs genannten Art so auszugestalten, daß sich ein günstigerer Kompromiß zwischen der Forderung nach einer verbesserten Auflösung bzw. einer Verringerung der Aliasing-Strukturen einerseits und der Dauer der Navigatorimpulse andererseits ergibt.

Eine erste Lösung dieser Aufgabe ist gekennzeichnet durch einen solchen zeitlichen Verlauf der Gradienten-Magnetfelder, daß zwei MR-Signale erzeugt werden, die einer Anregung im k-Raum entlang parallel gegeneinander versetzter Trajektorien entsprechen, und durch die Addition der MR-Signale.

Die zwei MR-Signale können mit zwei Hochfrequenzimpulsen erzeugt werden, wobei das in Verbindung damit wirksame Gradientenfeld $G_{y1}$, $G_{y2}$ so gestaltet wird, daß der k-Raum entlang parallel gegeneinander versetzter Trajektorien durchlaufen wird. Kombiniert man diese MR-Signale , dann kann man die gleiche räumliche Auflösung bzw. Verringerung der Aliasing-Strukturen erreichen, wie wenn der k-Raum entlang sämtlicher Trajektorien durch einen einzigen Hochfrequenzimpuls mit derselben Dauer angeregt würde.

Man kann diese MR-Signale aber auch dadurch erzeugen, daß man nur einen einzigen Hochfrequenzimpuls verwendet und die angeregte Kernmagnetisierung mehrfach entlang verschiedener Trajektorien ausliest. Damit erreicht man dieselbe Wirkung, als wenn man einen Hochfrequenzimpuls mit derselben Dauer und Gradientenfelder mit einer solchen Stärke verwenden würde, daß sämtliche (gegeneinander versetzten) Trajektorien bei diesem einen Hochfrequenzimpuls durchlaufen würden.

In Verbindung mit dieser Anregung des k-Raums ist es gemäß Anspruch 3 möglich, nach einem Hochfrequenzimpuls mindestens zwei MR-Signale zu gewinnen. Diese entsprechen den MR-Signalen, die sich nach Anregung durch mehrere Hochfrequenzimpulse ergeben würden, bei denen der k-Raum entlang mehrerer, gegeneinander versetzter Gruppen von Trajektorien durchlaufen würde.

Bei der Ausgestaltung nach Anspruch 3 wird der k-Raum sowohl während der Anregung als auch während der Auslesung entlang paralleler Trajektorien durchlaufen bzw. abgetastet. Dabei wird die Kernmagnetisierung aber nicht nur, wie erwünscht, in einem einzigen "pencil beam" angeregt, sondern durch die Aliasing-Effekte auch in weiteren Bereichen - sogenannten Aliasing-Peaks - die sich in der zweiten Richtung periodisch wiederholen und die Auswertung des Navigatorsignals beeinträchtigen. Mit der Ausgestaltung nach Anspruch 4 können die Wirkungen der beiden Aliasing-Peaks beiderseits des eigentlich anzuregenden Bereichs eliminiert werden, indem die beiden dabei akquirierten MR-Signale kombiniert werden. Mit der Ausgestaltung nach Anspruch 5 kann zusätzlich noch die Wirkung zweier weiterer Aliasing-Peaks kompensiert werden.

Während bei der Ausgestaltung nach den Ansprüchen 3 bis 5 mit nur einem Hochfrequenzimpuls mehrere (bzw. zwei bzw. vier) MR-Signale akquiriert werden, wird bei der Ausgestaltung nach Anspruch 6 pro Hochfrequenzimpuls nur ein MR-Signal empfangen. Ein solches Verfahren ist bei der fortlaufenden Erzeugung von Navigatorimpulsen sinnvoll, wobei sich die Trajektorien; entlang denen der k-Raum bei der Anregung durchlaufen wird, zyklisch ändern.

Eine zweite Lösung des der Erfindung zugrundeliegenden Problems ist in Anspruch 7 angegeben. Die Trajektorien, die dabei durchlaufen werden, sind auf eine Hälfte des k-Raums beschränkt. Der Realteil des Kernmagnetisierungsvektors bleibt dabei unverändert (gegenüber einem Verfahren bei dem beide Hälften des k-Raums mit der gleichen Dichte der Trajektorien durchlaufen werden), während der nun auftretende Imaginärteil zu einer Verbreiterung führt. Wird nun bei der Auswertung des Navigatorsignals anstelle des Absolutbetrages des MR-Signals nur der Realteil benutzt, so kann die gleiche räumliche Auflösung wie zuvor erzielt werden. Dieses Verfahren ist für alle Trajektorien einsetzbar, die den k-Raum symmetrisch anregen. Gemäß Anspruch 8 ist es aber besonders effektiv, wenn bei der Anregung der k-Raum entlang paralleler Trajektorien durchlaufen wird - analog zu der EPI-Sequenz beim Auslesen von MR-Signalen - .

Die erste Lösung - soweit sie sich auf zwei MR-Signale beschränkt - und die zweite Lösung nutzen bestimmte Effekte aus (daß die Wirkung der Aliasing Peaks sich durch die Kombination der MR-Signale eliminieren läßt, bzw. daß der Realteil der in diesen Peaks angeregten Kernmagnetisierung nicht zu einer Verbreiterung führt).

MR-Geräte zur Durchführung der MR-Verfahren nach den Ansprüchen 1 bzw. 7 sind in den Ansprüchen 9 bzw. 10 beschrieben. Die Ansprüche 11 und 12 definieren die Software für eine Steuereinheit eines MR-Gerätes mit der sich die Verfahren nach den Ansprüchen 1 bzw. 7 ausführen lassen.

Die Erfindung wird nachstehend anhand der Zeichnungen nähererläutert. Es zeigen:

Fig. 1          das Blockschaltbild eines MR-Gerätes, mit dem die Erfindung ausführbar ist,

Fig. 2          ein Ablaufdiagramm zur Erläuterung des erfindungsgemäßen Verfahrens,

Fig. 3          den zeitlichen Verlauf verschiedener Signale bei dem erfindungsgemäßen Verfahren,

Fig. 4          den zugehörigen Verlauf der Trajektorien im k-Raum,

Fig. 5a und 5b   verschiedene Modifikationen des Verfahrens nach Fig. 3,

Fig. 6 und 7     die Phasenlage in den dazu gehörenden Aliasing Peaks,

Fig. 8          den zeitlichen Verlauf verschiedener Magnetfelder bei einer anderen Ausführungsform der Erfindung und

Fig. 9          die dazugehörige Trajektorie im k-Raum.

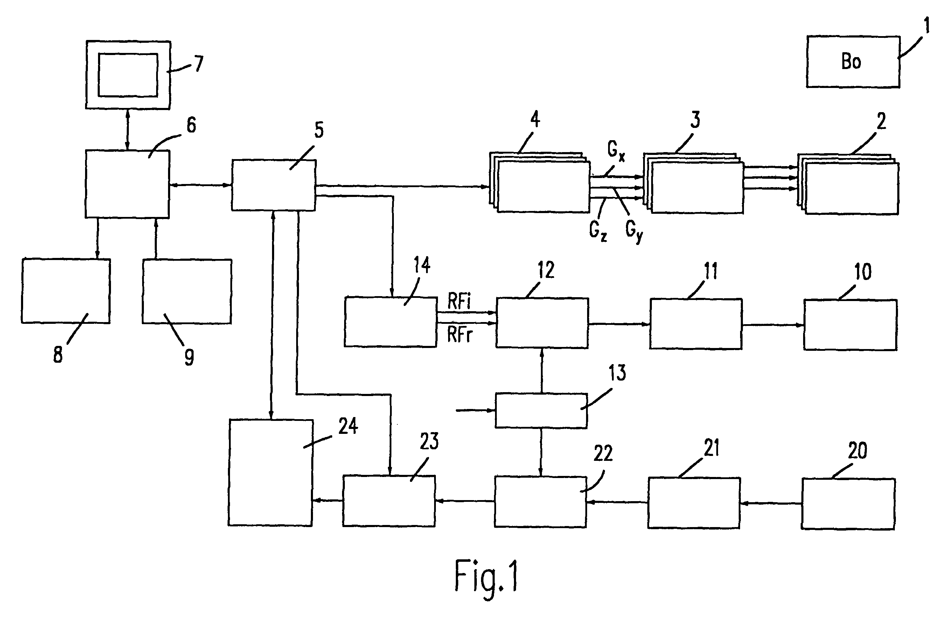

In Fig. 1 ist mit 1 ein schematisch dargestellter Hauptfeldmagnet bezeichnet, der in einem nicht näher dargestellten Untersuchungsbereich ein in z-Richtung verlaufendes stationäres und im wesentlichen homogenes Magnetfeld mit einer Stärke von z.B. 1,5 Tesla erzeugt. Die z-Richtung verläuft dabei in Längsrichtung eines nicht näher dargestellten Untersuchungstisches, auf dem sich während einer MR-Untersuchung ein Patient befindet.

Weiterhin ist eine Gradientenspulen-Anordnung 2 vorgesehen, die drei Spulensysteme umfaßt, mit denen in z-Richtung verlaufende Gradienten-Magnetfelder $G_x$, $G_y$ bzw. $G_z$ mit einem Gradienten in x, y bzw. z-Richtung erzeugt werden können. Die Ströme für die Gradientenspulen-Anordnung 2 werden von einem Gradientenverstärker 3 geliefert. Ihr zeitlicher Verlauf wird von einem Waveform-Generator 4 vorgegeben, und zwar für jede Richtung gesondert. Der Waveform-Generator 4 wird von einer Rechen- und Steuereinheit 5 gesteuert, die den für ein bestimmtes Untersuchungsverfahren erforderlichen zeitlichen Verlauf der magnetischen Gradientenfelder $G_x$, $G_y$, $G_z$ berechnet und in den Waveform-Generator 4 lädt. Bei der MR-Untersuchung werden diese Signale aus dem Waveform-Generator 4 ausgelesen und den Gradientenverstärkern 3 zugeführt, die daraus die für die Gradientenspulen-Anordnung 2 erforderlichen Ströme erzeugt.

Die Steuereinheit 5 wirkt außerdem noch auf eine Workstation 6 ein, die mit einem Monitor 7 zur Wiedergabe von MR-Bildern versehen ist. Über eine Tastatur 8 oder eine interaktive Eingabeeinheit 9 sind Eingaben möglich.

Die Kernmagnetisierung im Untersuchungsbereich kann durch Hochfrequenzimpulse einer Hochfrequenzspule 10 angeregt werden, die an einen Hochfrequenzverstärker 11 angeschlossen ist, der die Ausgangssignale eines Hochfrequenzsenders 12 verstärkt. In dem Hochfrequenzsender 12 werden die (komplexen) Einhüllenden der Hochfrequenzimpulse, auf die von einem Oszillator gelieferten Trägerschwingungen moduliert, deren Frequenz der Larmorfrequenz (bei einem Hauptfeld von 1,3 Tesla ca. 63 MHz) entspricht. Die komplexe Einhüllende wird von der Rechen- und Steuereinheit in einen Generator 14 geladen, der mit dem Sender 12 gekoppelt ist.

Die im Untersuchungsbereich erzeugten MR-Signale werden von einer Empfangsspule 20 aufgenommen und von einem Verstärker 21 verstärkt. Das verstärkte MR-Signal wird in einem Quadraturdemodulator 22 durch zwei um 90° gegeneinander versetzte Trägerschwingungen des Oszillators 13 demoduliert, so daß zwei Signale erzeugt werden, die als Realteil und als Imaginärteil eines komplexen MR-Signals aufgefaßt werden können. Diese Signale werden einem Analog-Digitalwandler 23 zugeführt, der daraus MR-Daten bildet. Die MR-Daten werden in einer Auswerteeinheit 24 verschiedenen Verarbeitungsschritten unterzogen, u.a. einer Fourier-Transformation.

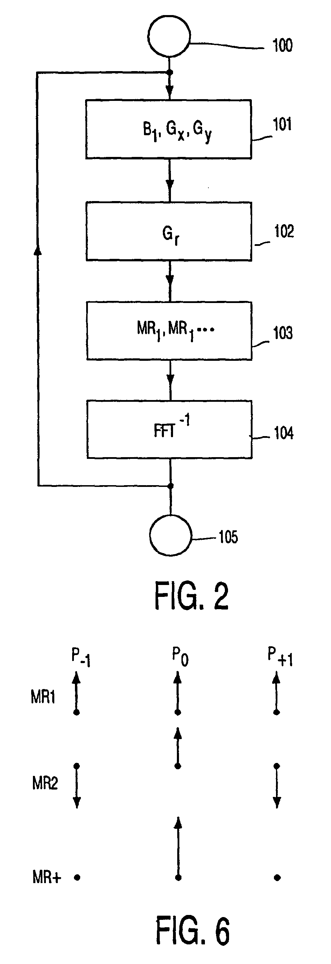

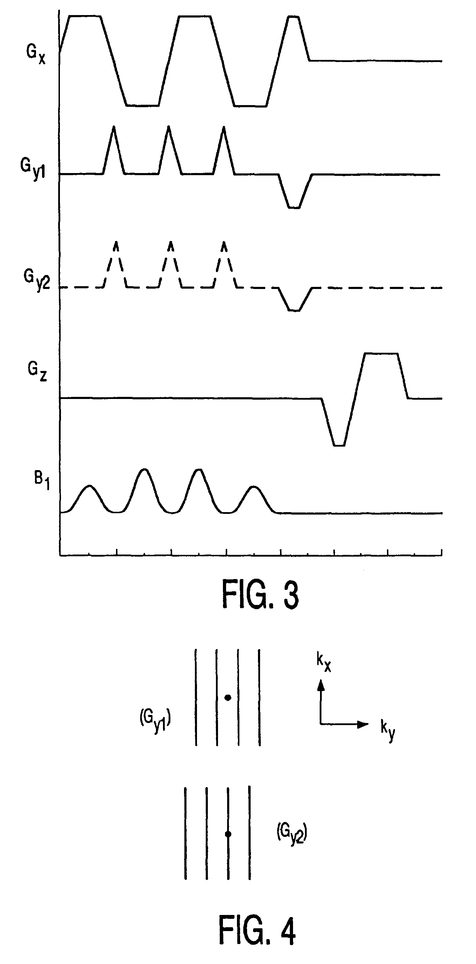

Der durch die Steuereinheit 5 gesteuerte Ablauf des erfindungsgemäßen Verfahrens ist in Fig. 2 dargestellt. Nach der Initialisierung im Block 100 wird ein Navigatorimpuls erzeugt (Block 101). Der dafür erforderliche zeitliche Verlauf der Gradienten-Magnetfelder und der Amplitude des Hochfrequenzimpulses ist in Fig. 3 dargestellt. Während der Anregungsphase sind außer dem Hochfrequenzimpuls $B_1$ (4. Zeile) ein Gradienten-Magnetfeld $G_x$ (1. Zeile) mit einem in x-Richtung verlaufenden Gradienten und ein Gradienten-Magnetfeld mit einem in y-Richtung verlaufenden Gradienten wirksam, wobei entweder der Verlauf $G_{y1}$ (2. Zeile) oder der Verlauf $G_{y2}$ (3. Zeile) von dem Waveform-Generator 4 (Fig. 1) vorgegeben wird.

Der Gradient $G_x$ ändert dabei seine Polarität mehrfach zwischen einem positiven und einem negativen Wert, wobei die beiden Werte dem Betrage nach gleich sind und der Übergang zwischen den beiden Werten rampenförmig erfolgt. Bei jedem dieser Polaritätswechsel wird ein kurzer Impuls erzeugt, ein sogenannter "blip", wobei die blips alle die gleiche Größe und die gleiche Polarität haben. In der Zeichnung sind der Einfachheit halber nur drei Polaritätswechsel bzw drei blips dargestellt. Man aber auch eine andere -insbesondere größere -Anzahl von Polaritätswechseln bzw. blips vorsehen, z.B. acht bis zwölf. Nach dem Hochfrequenzimpuls wird der Gradient $G_{y1}$ mit entgegengesetzter Polarität eingeschaltet und zwar so, daß das zeitliche Integral 1,5 mal so groß ist wie das zeitliche Integral über einen der "blips", also die Hälfte des zeitlichen Integrals über alle blips während des Hochfrequenzimpulses beträgt. Gleichzeitig wird eine positive Halbschwingung des Gradienten $G_x$ eingeschaltet, deren zeitliches Integral halb so groß ist wie das der vorangegangenen Halbschwingungen.

Die dazugehörige Trajektorie im k-Raum wird - siehe dazu den erwähnten Aufsatz von Nehrke, Börnert et al - durch die folgende Gleichung beschrieben:

$$k(t) = -\gamma \int_t^T G(t') \, dt' \qquad\qquad\qquad (1)$$

Dabei wird davon ausgegangen, daß der Hochfrequenzimpuls zur Zeit t'= 0 beginnt und zur Zeit t'= T endet. G stellt das magnetische Gradientenfeld dar, im Beispiel nach Fig. 3 das Gradientenfeld $G_x$ und $G_{y1}$. Die sich daraus ergebende Trajektorie ist in Fig. 4 (oberer Teil) dargestellt. Die Trajektorie umfaßt 4 äquidistante, zueinander parallele und in $k_x$-Richtung verlaufende Linien, die symmetrisch zum Null-Punkt ($k_x = 0$, $k_y = 0$) des k-Raums angeordnet sind. Diese Symmetrie resultiert aus dem angegeben zeitlichen Verlauf von $G_{y1}$ und $G_x$ nach dem Hochfrequenzimpuls.

Gemäß Fig. 2 wird nach der Anregung der Kernmagnetisierung im Schritt 102 ein Gradienten-Magnetfeld erzeugt, der sog. Lesegradient, und zwar in Form eines in z-Richtung verlaufenden Gradienten, wobei auf eine Halbschwingung mit einer ersten (negativen) Polarität eine Halbschwingung mit der entgegengesetzten Polarität erfolgt, wobei das zeitliche Integral über die zweite Halbschwingung gerade doppelt so groß ist wie das zeitliche Integral über die erste Halbschwingung, so daß der k-Raum symmetrisch zu seinem Nullpunkt abgetastet wird.

Das während der positiven Polarität des Gradienten auftretende MR-Signal (MR1) wird im Block 103 empfangen und digitalisiert und anschließend verarbeitet, insbesondere einer Fourier-Transformation unterzogen.

Danach wird die Sequenz wiederholt, wobei jedoch der in y-Richtung verlaufende Gradient statt des Verlaufes $G_{y1}$ (2. Zeile) den gestrichelt angedeuteten Verlauf $G_{y2}$ (3. Zeile von Fig. 3) annimmt. Lage und zeitlicher Verlauf der blips sind dabei identisch zu $G_{y1}$; lediglich die negative Halbschwingung unterscheidet sich von der von $G_{y1}$ insofern als das zeitliche Integral darüber gerade dem zeitlichen Integral über einen Blip entspricht, d.h. um die Hälfte eines blips kleiner ist als bei $G_{y1}$. Infolgedessen ist die resultierende Trajektorie im k-Raum (unten) gegenüber der Trajektorie bei der vorherigen Anregung (oben) um den halben Abstand zwischen zwei benachbarten Linien versetzt. Eine der k-Raum Linien verläuft also durch den Nullpunkt des k-Raums. Das nach dieser Anregung entstehende MR-Signal (MR2) wird auf gleiche Weise ausgelesen (Block 103) und verarbeitet wie nach der ersten Anregung, und die beiden MR-Signale werden entweder vor oder nach der Fourier-Transformation addiert.

Die Wirkung dieser Maßnahme wird nachfolgend anhand von Fig. 6 erläutert. Wie bereits ausgeführt, wird die Kernmagnetisierung nicht nur in dem gewünschten Bereich (dieser ist in Fig. 6 mit $P_0$ bezeichnet) angeregt, sondern es ergeben sich weitere Peaks der Kernmagnetisierung (die beiden nächsten sind in Fig. 6 mit $P_{-1}$ und $P_{+1}$ bezeichnet), die sich periodisch wiederholen. Die Breite der Peaks ist um so geringer, je größer der größte k-Wert $k_{max}$ ist.

Es sei angenommen, daß die Vektoren der Kernmagnetisierung in den Peaks bei dem ersten MR-Signal MR1 den in Fig.6 dargestellten Verlauf haben. Dann kehren sich aufgrund der Verschiebung um eine halbe Linie im k-Raum bei dem zweiten MR-Signal MR2 die Vorzeichen der beiden benachbarten Peaks $P_{-1}$ und $P_{+1}$ um. Durch die Addition beider MR-Signale kompensieren sich also die Peaks an den Stellen $P_{-1}$ und $P_{+1}$, und es bleibt lediglich im Bereich $P_0$ Kernmagnetisierung bestehen, weil die Kernmagnetisierung in beiden Signalen dieselbe Phase hat.

Wie noch zu zeigen ist, bleiben auch die in Fig. 6 nicht dargestellten Peaks links und rechts unbeeinflußt. Die Kombination und Fourier-Transformation der beiden MR-Signale MR1 und MR2 hat also den gleichen Effekt wie ein Navigatorimpuls, dessen Trajektorie die doppelte Zahl der k-Raum Linien bei halbem Abstand der Linien voneinander aufweisen würde. Ein solcher Navigatorimpuls würde aber Gradientenmagnetfelder mit stärkeren Gradienten erfordern, so daß der k-Raum schneller durchlaufen werden könnte, oder eine längere Impulsdauer, was dazu führen würde, daß sich die Peaks aufgrund der Inhomogenitäten des stationären Magnetfeldes verbreitern würden.

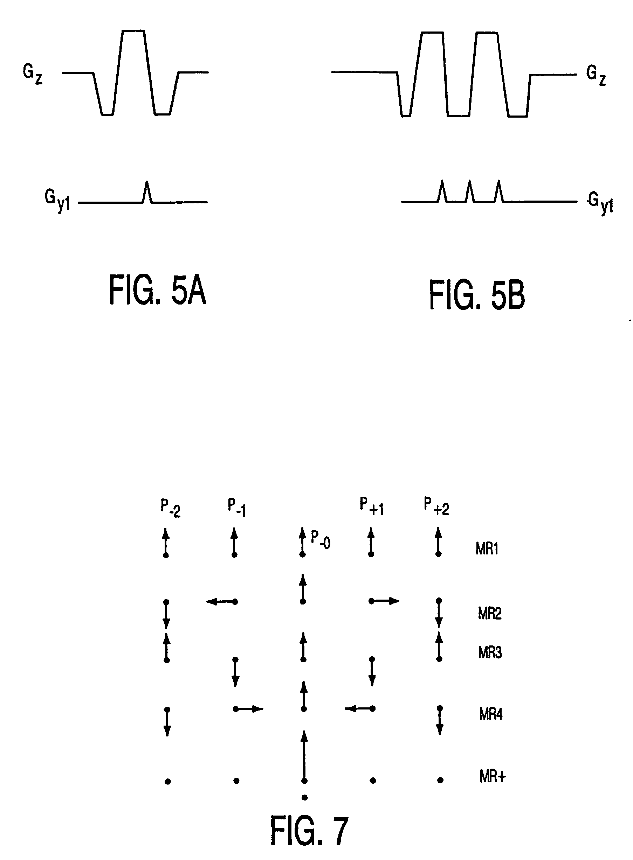

Die anhand von Fig. 3 erläuterte Ausführungsform setzt voraus, daß die Navigatorimpulse fortlaufend und in dichtem Abstand voneinander erzeugt werden, wobei alternierend die Gradientenverläufe $G_{y1}$ und $G_{y2}$ benutzt werden. Für eine Messung müssen die MR-Signale von zwei aufeinanderfolgenden Navigatorimpulsen kombiniert werden. Es ist aber auch möglich, das gleiche Resultat mit nur einem Navigatorimpuls zu erzielen, wie im folgenden anhand der in den Fig. 5a und 5b dargestellten Modifikationen der Sequenz nach Fig. 3 erläutert wird. Das Gradienten-Magnetfeld $G_{y2}$ (dritte Zeile von Fig. 3) entfällt dabei ganz, und es erfolgt lediglich eine Modifikation von $G_z$ und $G_{y1}$ nach dem Navigatorimpuls. Gemäß Fig. 5a folgt dabei auf die positive Halbschwingung des Lesegradienten $G_z$, in der ein erstes MR-Signal ausgelesen wird (MR1), eine negative Halbschwingung, in der ein zweites MR-Signal (MR2) ausgelesen wird. Während des Polaritätswechsels des Lesgadienten wirdzusätzlich zu dem in der zweiten Zeile von Fig. 3 dargestellten Verlauf ein blip des magnetischen Gradientenfeldes $G_{y1}$ eingeschaltet. Das zeitliche Integral über diesen blip ist halb so groß wie das zeitliche Integral über jeden der blips während des Navigatorimpulses.

Dadurch wird die Trajektorie in Fig. 4 oben um die Hälfte des Abstandes zweier benachbarter Linien dieser Trajektorie in $k_y$-Richtung verschoben , so daß sich die untere Trajektorie ergibt. Die beiden resultierenden MR-Signale werden unter Beachtung der (aus der Refokusierung durch die zweite Halbschwingung des Lesegradienten resultierenden) Zeitumkehr addiert und dann Fourier-transformiert. Auch hierbei mitteln sich die Beiträge der Aliasing Peaks jeweils heraus.

Mit den in den Fig. 3 und 5a erläuterten Ausführungsformen des erfindungsgemäßen Verfahrens ist es möglich, die Wirkung der Aliasing Peaks zu kompensieren, die dem anzuregenden Bereich ($P_0$ in Fig. 6) benachbart sind. Dies kann in verschiedenen Fällen ausreichend sein. Jedoch wird die Wirkung der weiter außen liegenden Peaks damit nicht beeinflußt. In Verbindung mit Fig. 5b wird nun eine Modifikation der Sequenz nach Fig. 3 bzw. 5a erläutert, die es gestattet, auch die Wirkung der übernächsten Aliasing Peaks zu kompensieren.

Zu diesem Zweck wird der in Fig. 5a dargestellte Verlauf von $G_z$ und $G_{y1}$ (nach dem Navigatorimpuls) durch den in Fig. 5b dargestellten Verlauf ersetzt. Dabei sind vier Halbschwingungen des Lesgradienten $G_z$ vorgesehen (anstelle von zwei), während denen jeweils ein MR-Signal empfangen wird. Bei jedem der drei Polaritätswechsel von einer positiven zu einer negativen Polarität und umgekehrt wird ein blip des Gradienten $G_{y1}$ erzeugt. Das zeitliche Integral über einen solchen blip beträgt ein Viertel des zeitlichen Integrals über einen blip während des Navigatorimpulses. Den vier empfangenen MR-Signalen MR1, MR2, MR3, MR4 sind daher vier Trajektorien zugeordnet, die gegeneinander jeweils um ein Viertel des Abstandes zweier Linien im k-Raum einer Trajektorie versetzt sind (statt um die Hälfte, wie in Fig, 4 angedeutet).

Die Wirkung dieser Maßnahme ergibt sich aus Fig. 7, bei der angenommen wird, daß die Phase der Kernmagnetisierung in den Bereichen $P_{-2}$ bis $P_{+2}$ beim Empfang des ersten Signals MR1 die angegebene Richtung hat. Bei dem zweiten MR-Signal MR2 ist die Phase in den Bereichen $P_{-1}$ und $P_{+1}$ um 90° gedreht, während die Phase in den übernächsten Bereichen $P_{-2}$ und $P_{+2}$ um 180° gedreht ist. Beim dritten MR-Signal MR3 ergibt sich die gleiche Phasenlage, wie in Fig. 6 für die drei innersten Peaks angedeutet, d.h. im Vergleich zum ersten MR-Signal MR1 ist die Phasenlage im Bereich $P_0$ weiterhin unverändert, während sie in den Bereichen $P_{-1}$ und $P_{+1}$ invertiert ist. In den Bereichen $P_{-2}$ und $P_{+2}$ ist sie wiederum so wie beim Signal MR1. Beim vierten Signal MR4 schließlich ist die Phasenlage im Bereich $P_0$ immer noch unverändert, während in den Bereichen $P_{-1}$ und $P_{+1}$ die Phase gegenüber dem ersten Signal um 90° und gegenüber dem zweiten Signal um 180° gedreht ist. Die Phasenlage in den übernächsten Aliasing Peaks, d.h. in den Bereichen $P_{-2}$ und $P_{+2}$ ist gegenüber dem ersten MR-Signal MR1 wiederum invertiert.

Addiert man nun alle MR-Signale - wiederum unter Berücksichtigung der durch die Refokussierung erfolgenden Zeitumkehr - dann kompensieren sich die Wirkungen der nächsten ($P_{-1}$, $P_{+1}$) und der übernächsten ($P_{-2}$, $P_{+2}$) Aliasing Peaks, während die Wirkungen des zentralen Bereiches sich addieren. Das aus der Kombination resultierende Fourier-transformierte Signal wird also lediglich durch die Protonendichte in dem zylinderförmigen Stab (Pencil Beam) beeinflußt, der dem Bereich $P_0$ entspricht.

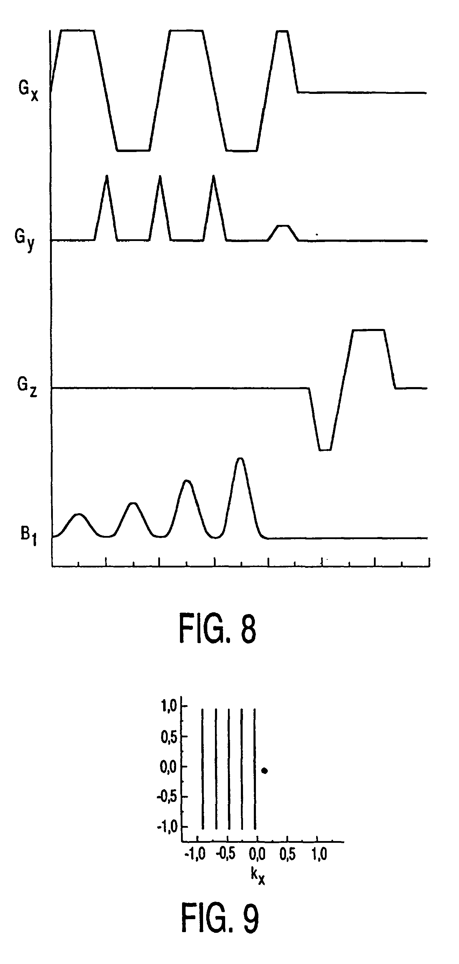

Im folgenden wird eine weitere Ausführungsform anhand der Figuren 8 und 9 erläutert. Fig. 8 zeigt den zeitlichen Verlauf der Gradienten-Magnetfelder während der Anregung bzw. während des Auslesens. Gegenüber der Sequenz nach Fig. 3 ergeben sich folgende Unterschiede: Das zeitliche Integral über den Rephasiergradienten, d.h. über die negative Halbschwingung von $G_{y1}$ nach dem Hochfrequenzimpuls, ist halb so groß wie das zeitliche Integral über einen blip. Die Mitte (der Nullpunkt) des k-Raums wird daher nicht in der zeitlichen Mitte des Hochfrequenzimpulses erreicht wird sondern an dessen Ende. Infolgedessen erreicht auch die Amplitude ihr Maximum nicht in der Mitte des Hochfrequenzimplses sondern an seinem Ende. Die Trajektorie befindet sich infolgedessen lediglich in der einen Hälfte des k-Raums..

Es läßt sich zeigen, daß bei einer solchen Trajektorie der Realteil die gleiche Peakbreite und den gleichen Abstand der Aliasing Peaks hat wie ein Navigatorimpuls, dessen Trajektorie doppelt so viele Linien im k-Raum hat wie die in Fig. 9 dargestellte und symmetrisch zur Mitte des k-Raums verläuft. Im Imaginärteil des Anregungsprofils ergibt sich demgegenüber aber eine Verbreiterung. Wird nun bei der Auswertung des Navigatorsignals statt des Absolutbetrages des MR-Signals nur dessen Realteil benutzt, so kann die gleiche Auflösung bzw. eine Vergrößerung des Abstandes der Aliasing Peaks erzielt werden wie bei einem Navigatorimpuls, dessen Trajektorie (mit der doppelten Linienzahl und demselben Abstand der Linien voneinander) symmetrisch zur Mitte des k-Raums verläuft.

Die Auswertung nur des Realteils des MR-Signals setzt voraus, daß das MR-Signal phasenempfindlich detektiert werden kann, was -wie in Verbindung mit Fig. 1 erläutert - der Fall ist. Außerdem können sich noch Phasenverschiebungen ergeben, die korrigiert werden müssen. Eine konstante Phase ergibt sich u.a. aus der zeitlichen Lage der Abtastzeitpunkte bei der Digitalisierung des MR-Signal. Sie kann bestimmt werden, indem in der Sequenz nach Fig. 8 alle Gradienten ausgeschaltet werden, so daß nur der Hochfrequenzimpuls $B_1$ wirksam ist.

Eine zeitlich linear veränderliche Phase ergibt sich aus der Position des Lesegradienten $G_z$ in Fig. 8 im Bezug auf das Spinsystem. Diese Phase kann bestimmt werden, in dem die Sequenz nach Fig. 8 ohne die in der Anregungsphase wirksamen Gradienten $G_x$ und $G_y$ durchgeführt wird.

**Patentansprüche**

1.  MR-Verfahren, bei dem mindestens ein Navigatorimpuls zur Anregung der Kernmagnetisierung in einem räumlich begrenzten Bereich mittels jeweils eines Hochfrequenzimpulses und wenigstens zweier Gradienten-Magnetfelder ($G_x$; $G_{y1}$, $G_{y2}$) mit zeitlich und räumlich unterschiedlich verlaufenden Gradienten erzeugt wird, wonach mindestens ein MR-Signal aus dem Bereich in Verbindung mit einem weiteren Gradienten-Magnetfeld ($G_z$) empfangen und ausgewertet wird,
    <u>**gekennzeichnet durch**</u> einen solchen zeitlichen Verlauf der Gradienten-Magnetfelder ($G_{y1}$, $G_{y2}$, $g_z$), daß zwei MR-Signale erzeugt werden, die einer Anregung im k-Raum entlang parallel gegeneinander versetzter Trajektorien entsprechen, und **durch** die Addition der zwei MR-Signale .

2.  MR-Verfahren nach Anspruch 1,
    <u>**gekennzeichnet durch**</u>

    • die Erzeugung des ersten Gradienten-Magnetfeldes ($G_x$) während des zugehörigen Hochfrequenzimpulses, dessen Gradient in einer ersten Richtung verläuft und dessen Polarität mehrfach zwischen einem positiven und einem negativen Wert wechselt und **durch**
    • die Erzeugung des zweiten Gradienten-Magnetfeldes ($G_{y1}$; $G_{y2}$), dessen Gradient in einer zweiten Richtung verläuft, während der Polaritätswechsel des ersten Gradienten-Magnetfeldes ($G_x$).

3.  MR-Verfahren nach Anspruch 2,
    <u>**gekennzeichnet durch**</u>

    • die Erzeugung des weiteren Gradienten-Magnetfeldes ($G_z$) nach dem Hochfrequenzimpuls, dessen Gradient in einer dritten Richtung verläuft und dessen Polarität mindestens einmal zwischen einem positiven und einem negativen Wert wechselt,
    • die Erzeugung eines Gradienten-Magnetfeldes ($G_{y1}$; $G_{y2}$) mit in der zweiten Richtung verlaufendem Gradienten während der Polaritätswechsel des weiteren Gradienten- Magnetfeldes ($g_z$), dessen Gradient in der zweiten Richtung verläuft, wobei das zeitliche Integral über diesen Gradienten kleiner ist als während des Hochfrequenzimpulses,
    • das Auslesen jeweils eines MR-Signals bei jeweils einer Polarität des weiteren Gradienten-Magnetfeldes ($G_z$) und **durch**
    • die Addition dieser MR-Signale.

4.  MR-Verfahren nach Anspruch 3,
    <u>**dadurch gekennzeichnet,**</u>

    • **daß** die Polarität des weiteren Gradienten-Magnetfeldes ($G_z$) einmal wechselt und
    • **daß** das zeitliche Integral über den zweiten Gradienten halb so groß ist wie das zeitliche Integral über diesen Gradienten während eines Polaritätswechsels des ersten Gradienten-Magnetfeldes ($G_x$).

5.  MR-Verfahren nach Anspruch 3,
    <u>**dadurch gekennzeichnet,**</u>

    • **daß** die Polarität des dritten Gradienten-Magnetfeldes ($G_z$) zweimal von der einen Polarität zur anderen wechselt und
    • **daß** das zeitliche Integral über den zweiten Gradienten während eines solchen Polaritätswechsels ein Viertel des zeitlichen Integrals über den zweiten Gradienten während eines Polaritätswechsels des ersten Gradienten-Magnetfeldes ($G_x$) ist.

6.  MR-Verfahren nach Anspruch 1,

**gekennzeichnet durch**

> • die Anregung eines Bereiches **durch** mehrere Navigatorimpulse entlang parallel gegeneinander versetzter Trajektorien im k-Raum
> • Empfangen je eines der MR-Signale.

7.  MR-Verfahren, bei dem ein Navigatorimpuls zur Anregung der Kernmagnetisierung in einem räumlich begrenzten Bereich mittels eines Hochfrequenzimpulses und wenigstens zweier Gradienten-Magnetfelder ($G_x$; $G_{y1}$, $G_{y2}$) mit zeitlich und räumlich unterschiedlich verlaufenden Gradienten erzeugt wird, wonach mindestens ein MR-Signal aus dem Bereich in Verbindung mit einem weiteren Gradienten-Magnetfeld ($G_z$) empfangen und ausgewertet wird,
    **gekennzeichnet durch**

> • die Erzeugung der Gradienten-Magnetfelder ($G_x$; $G_{y1}$, $G_{y2}$, $G_z$) während der Anregung mit einem solchen zeitlichen Verlauf, daß die Trajektorien auf eine Hälfte des k-Raums beschränkt sind
> • den phasenempfindlichen Empfang des resultierenden, einen Realteil und einen Imaginärteil umfassenden MR-Signals,
> • die Auswertung lediglich des Realteils des MR-Signals.

8.  MR-Verfahren nach Anspruch 7,
    **gekennzeichnet durch**

> • die Erzeugung eines ersten Gradienten-Magnetfeldes ($G_x$) während des Hochfrequenzimpulses, dessen Gradient in einer ersten Richtung verläuft und dessen Polarität mehrfach zwischen einem positiven und einem negativen Wert wechselt und **durch**
> • die Erzeugung eines zweiten Gradienten-Magnetfeldes ($G_{y1}$, $G_{y2}$), dessen Gradient in einer zweiten Richtung verläuft, während der Polaritätswechsel des ersten Gradienten-Magnetfeldes ($G_x$).

9.  MR-Gerät zur Durchführung des Verfahrens nach Anspruch 1,
    mit

> • einem Hochfrequenzsender (12) zur Erzeugung von magnetischen Hochfrequenzimpulsen
> • einem Empfänger zum Empfangen von MR-Signalen
> • einem Generator (4) zur Erzeugung von Gradienten-Magnetfeldern ($G_x$, $G_{y1}$, $G_{y2}$, $G_z$) mit zeitlich und räumlich unterschiedlich verlaufenden Gradienten
> • einer Auswerteeinheit (24) zur Verarbeitung der empfangenen MR-Signale und
> • und einer den Hochfrequenzsender (12), den Empfänger, den Generator (4), und die Auswerteeinheit (24) steuernden Steuereinheit (5), die so programmiert ist, daß sie Kernmagnetisierung in einem Untersuchungsbereich durch wenigstens einen Hochfrequenzimpuls anregt,

**dadurch gekennzeichnet, daß** die Steuereinheit außerdem so programmiert ist, daß folgende Schritte ausgeführt werden:

> • Erzeugung von Gradienten-Magnetfeldern ($G_{y1}$, $G_{y2}$ $g_z$) mit einem solchen zeitlichen Verlauf, daß wenigstens zwei MR-Signale erzeugt werden, die einer Anregung im k-Raum entlang parallel gegeneinander versetzter Trajektorien entsprechen,
> • Empfangen und Addieren der MR-Signale.

10. MR-Gerät zur Durchführung des Verfahrens nach Anspruch 7
    mit

> • einem Hochfrequenzsender (12) zur Erzeugung von magnetischen Hochfrequenzimpulsen
> • einem Empfänger zum Empfangen von MR-Signalen
> • einem Generator (4) zur Erzeugung von Gradienten-Magnetfeldern ($G_x$, $G_{y1}$, $G_{y2}$, $G_z$) mit zeitlich und räumlich unterschiedlich verlaufenden Gradienten
> • einer Auswerteeinheit (24) zur Verarbeitung der empfangenen MR-Signale und
> • und einer den Hochfrequenzsender (12), den Empfänger, den Generator (4), und die Auswerteeinheit (24) steuernden Steuereinheit (5), die so programmiert ist, daß sie Kernmagnetisierung in einem Untersuchungsbereich durch einen Hochfrequenzimpuls anregt,

**dadurch gekennzeichnet, daß** die Steuereinheit außerdem so programmiert ist, daß folgende Schritte ausgeführt werden:

• Erzeugung von Gradienten-Magnetfeldern ($G_x$, $G_{y1}$, $G_{y2}$, $G_z$) während der Anregung mit einem solchen zeitlichen Verlauf, daß die Trajektorien auf eine Hälfte des k-Raums beschränkt sind
• phasenempfindlicher Empfang des resultierenden, einen Realteil und einen Imaginärteil umfassenden MR-Signals
• Auswertung lediglich des Realteils des MR-Signals.

11. Computerprogramm für eine Steuereinheit (5) eines MR-Gerätes zur Steuerung eines Hochfrequenzsenders (12), eines Empfängers, eines Generators (4), und einer Auswerteeinheit (24) zur Durchführung des Verfahrens nach Anspruch 1 gemäß folgendem Ablauf:

• Anregung von Kernmagnetisierung in einem Untersuchungsbereich durch Hochfrequenzimpuls pro Navigatorimpuls
• Erzeugung von Gradienten-Magnetfeldern ($G_{y1}$, $G_{y2}$ $g_z$) mit einem solchen zeitlichen Verlauf, daß wenigstens zwei MR-Signale erzeugt werden, die einer Anregung im k-Raum entlang parallel gegeneinander versetzter Trajektorien entsprechen
• Empfangen und Addieren der MR-Signale.

12. Computerprogramm für eine Steuereinheit (5) eines MR-Gerätes zur Steuerung eines Hochfrequenzsenders (12), eines Empfängers, eines Generators (4), und einer Auswerteeinheit (24) zur Durchführung des Verfahrens nach Anspruch 7 gemäß folgendem Ablauf:

• Anregung von Kernmagnetisierung in einem Untersuchungsbereich durch einen Hochfrequenzimpuls
• Erzeugung von Gradienten-Magnetfeldern ($G_x$, $G_{y1}$, $G_{y2}$, $G_z$) während der Anregung mit einem solchen zeitlichen Verlauf, daß die Trajektorien auf eine Hälfte des k-Raums beschränkt sind
• phasenempfindlicher Empfang des resultierenden, einen Realteil und einen Imaginärteil umfassenden MR-Signals
• Auswertung lediglich des Realteils des MR-Signals.


**Claims**

1. An MR method in which at least one navigator pulse is generated so as to excite the nuclear magnetization in a spatially limited volume by means of one RF pulse each and at least two gradient magnetic fields ($G_x$; $G_{y1}$, $G_{y2}$) having gradients which extend differently in respect of time and space, after which at least one MR signal is received from the volume, in conjunction with a further gradient magnetic field ($G_z$), so as to be evaluated, **characterized by** such a variation in time of the gradient magnetic fields ($G_x$; $G_{y1}$, $G_{y2}$) that two MR signals are generated which correspond to an excitation in the k space along parallel mutually offset trajectories, and by the fact that MR signals are added together.

2. An MR method as claimed in claim 1, **characterized in that**

• the first gradient magnetic field ($G_x$) is generated during the associated RF pulse, its gradient extending in a first direction and its polarity being repeatedly reversed between a positive and a negative value, and **in that**
• the second gradient magnetic field ($G_{y1}$; $G_{y2}$), having a gradient extending in a second direction, is generated during the polarity reversal of the first gradient magnetic field ($G_x$).

3. An MR method as claimed in claim 2, **characterized in that**

• the third gradient magnetic field ($G_z$) is generated after the RF pulse, its gradient extending in a third direction and its polarity being reversed at least once between a positive and a negative value,
• a gradient magnetic field ($G_{y1}$; $G_{y2}$) is generated with a gradient extending in the second direction during the reversal of the polarity of the further gradient magnetic field ($G_z$) whose gradient extends in the second direction, the time integral over this gradient being smaller than that during the RF pulse,
• a respective MR signal is read out each time for a polarity of the further gradient magnetic field ($G_z$), and **in that**
• these MR signals are added together.

**4.** An MR method as claimed in claim 3, **characterized in that**

• the polarity of the further gradient magnetic field ($G_z$) is reversed once, and **in that**
• the time integral over the second gradient amounts to half the time integral over this gradient during a polarity reversal of the first gradient magnetic field ($G_x$).

**5.** An MR method as claimed in claim 3, **characterized in that**

• the polarity of the further gradient magnetic field ($G_z$) is reversed twice from one polarity to the other, and **in that**
• during such a polarity reversal the time integral over the second gradient amounts to one quarter of the time integral over the second gradient during a polarity reversal of the first gradient magnetic field ($G_x$).

**6.** An MR method as claimed in claim 1, **characterized by** the fact that

• a region is excited by a plurality of navigator pulses along parallel mutually offset trajectories in the k space,
• a respective one of the MR signals is received.

**7.** An MR method in which a navigator pulse is generated so as to excite the nuclear magnetization in a spatially limited volume by means of one RF pulse and at least two gradient magnetic fields ($G_x$; $G_{y1}$, $G_{y2}$) having gradients which extend differently in respect of time and space, after which at least one MR signal is received from the volume in conjunction with a further gradient magnetic field, so as to be evaluated, **characterized in that**

• during the excitation the gradient magnetic fields ($G_x$; $G_{y1}$, $G_{y2}$, $G_z$) are generated with a variation in time such that the trajectories are limited to one half of the k space,
• the resultant MR signal, comprising a real part and an imaginary part, is received in a phase-sensitive manner, and
• only the real part of the MR signal is evaluated.

**8.** An MR method as claimed in claim 7, **characterized in that**

• a first gradient magnetic field ($G_x$) is generated during the RF pulse, its gradient extending in a first direction and its polarity being repeatedly reversed between a positive and a negative value, and **in that**
• a second gradient magnetic field ($G_{y1}$, $G_{y2}$), having a gradient extending in a second direction, is generated during the polarity reversal of the first gradient magnetic field ($G_x$).

**9.** An MR apparatus for carrying out the method as claimed in claim 1, comprising

• an RF transmitter (12) for generating magnetic RF pulses,
• a receiver for receiving MR signals,
• a generator (4) for generating gradient magnetic fields ($G_x$; $G_{y1}$, $G_{y2}$, $G_z$) having gradients which extend differently in respect of time and space,
• an evaluation unit (24) for processing the MR signals received, and
• a control unit (5) which controls the RF transmitter (12), the receiver, the generator (4) and the evaluation unit (24) and is programmed in such a manner that it excites
• nuclear magnetization in an examination zone by means of at least one RF pulse, **characterized in that** the control unit is further programmed such that the following steps are carried out:
• the generating of gradient magnetic fields ($G_{y1}$, $G_{y2}$, $G_z$) which vary in time in such a manner that at least two MR signals are generated which correspond to an excitation in the k space along parallel mutually offset trajectories,
• the reception and adding together of the MR signals.

**10.** An MR apparatus for carrying out the method claimed in claim 7, comprising

• an RF transmitter (12) for generating magnetic RF pulses,
• a receiver for receiving MR signals,
• a generator (4) for generating gradient magnetic fields ($G_x$; $G_{y1}$, $G_{y2}$, $G_z$) having gradients which extend differently in respect of time and space,
• an evaluation unit (24) for processing the MR signals received, and

• a control unit (5) which controls the RF transmitter (12), the receiver, the generator (4) and the evaluation unit (24) and is programmed in such a manner that it excites

• nuclear magnetization in an examination zone by means of one RF pulse, **characterized in that** the control unit is further programmed such that the following steps are carried out:

• the generating of gradient magnetic fields ($G_x$; $G_{y1}$, $G_{y2}$, $G_z$) during the excitation, which fields vary in time in such a manner that the trajectories are limited to one half of the k space,
• the phase-sensitive reception of the resultant MR signal which comprises a real part and an imaginary part,
• the evaluation of only the real part of the MR signal.

11. A computer program for a control unit (5) of an MR apparatus which is intended to control an RF transmitter (12), a receiver, a generator (4), and an evaluation unit (24) so as to carry out the method claimed in claim 1, having the following routine:

• excitation of the nuclear magnetization in an examination zone by means of one RF pulse per navigator pulse,
• generating of gradient magnetic fields ($G_{y1}$, $G_{y2}$, $G_z$) with a variation in time such that there are generated at least two MR signals which correspond to an excitation in the k space along parallel mutually offset trajectories,
• reception and adding together of the MR signals.

12. A computer program for a control unit (5) of an MR apparatus which is intended to control an RF transmitter (12), a receiver, a generator (4) and an evaluation unit (24) so as to carry out the method claimed in claim 7, having the following routine:

• excitation of nuclear magnetization in an examination zone by means of one RF pulse,
• generating of gradient magnetic fields ($G_x$; $G_{y1}$, $G_{y2}$, $G_z$)during the excitation, which fields vary in time in such a manner that the trajectories are limited to one half of the k space,
• phase-sensitive reception of the resultant MR signal which comprises a real part and an imaginary part,
• evaluation of only the real part of the MR signal.

## Revendications

1. Procédé RM dans lequel une impulsion navigatrice est produite pour l'excitation de la magnétisation nucléaire dans une zone délimitée spatialement à l'aide d'au moins une impulsion à haute fréquence et d'au moins deux champs magnétiques à gradient ($G_x$, $G_{y1}$, $G_{y2}$) avec des gradients évoluant différemment dans le temps et l'espace, selon laquelle au moins un signal RM de la zone en relation avec un champ magnétique à gradient ($G_z$) supplémentaire est reçu et évalué,
   <u>caractérisé par</u> un tracé temporel du champ magnétique à gradient ($G_{y1}$, $G_{y2}$) tel qu'il soit produit au moins deux signaux RM qui correspondent à une excitation dans l'espace k le long de deux trajectoires décalées parallèlement l'une de l'autre et par l'addition des deux signaux RM du champ magnétique à gradient ($G_{y1}$, $G_{y2}$).

2. Procédé RM selon la revendication 1,
   <u>caractérisé par</u>

   • la production du premier champ magnétique à gradient ($G_x$) pendant l'impulsion à haute fréquence dont le gradient s'étend dans une première direction et dont la polarité change plusieurs fois entre une valeur positive et une valeur négative et par
   • la production du deuxième champ magnétique à gradient ($G_{y1}$, $G_{y2}$) dont le gradient évolue dans une deuxième direction pendant le changement de polarité du premier champ à gradient magnétique ($G_x$).

3. Procédé RM selon la revendication 3,
   <u>caractérisé par</u>

   • la production du troisième champ à gradient magnétique ($G_z$) après l'impulsion à haute fréquence dont le gradient s'étend dans une troisième direction et dont la polarité change au moins une fois entre une valeur positive et une valeur négative;
   • la production d'un champ magnétique à gradient ($G_{y1}$, $G_{y2}$) avec des gradients évoluant dans la deuxième direction pendant le changement de polarité du premier champ, dont le gradient évolue dans la deuxième direction, l'intégrale temporelle sur ces gradients étant moins élevée que pendant l'impulsion à haute fréquence,
• la lecture d'un signal RM respectif pour une polarité respective du troisième champ magnétique à gradient ($G_z$) et par
• l'addition de ces signaux RM.

**4.** Procédé RM selon la revendication 3,
**<u>caractérisé en ce</u>**

• **que** la polarité du troisième champ magnétique à gradient ($G_z$) change une fois et que
• l'intégrale temporelle sur les deuxièmes gradients est deux fois moins élevée que l'intégrale temporelle sur ces gradients pendant un changement de polarité du premier champ à gradient magnétique ($G_x$).

**5.** Procédé RM selon la revendication 4,
**<u>caractérisé en ce</u>**

• **que** la polarité du troisième champ magnétique à gradient ($G_z$) change deux fois d'une polarité à l'autre et que
• l'intégrale temporelle sur les deuxièmes gradients pendant un tel changement de polarité est un quart de l'intégrale temporelle sur les deuxièmes gradients pendant un changement de polarité du premier champ à gradient magnétique ($G_x$).

**6.** Procédé RM selon la revendication 1,
**<u>caractérisé par</u>**

• l'excitation d'une zone par plusieurs impulsions navigatrices le long de trajectoires décalées l'une par rapport à l'autre dans l'espace k;
• la réception d'un signal RM respectif;
• l'addition des signaux RM.

**7.** Procédé RM dans lequel une impulsion navigatrice est produite pour l'excitation de la magnétisation nucléaire dans une zone délimitée spatialement à l'aide d'au moins une impulsion à haute fréquence et d'au moins deux champs magnétiques à gradient ($G_x$, $G_{y1}$, $G_{y2}$) avec des gradients évoluant différemment dans le temps et l'espace, selon laquelle au moins un signal RM de la zone en relation avec un champ magnétique à gradient ($G_z$) supplémentaire est reçu et évalué, en particulier selon la revendication 1
**<u>caractérisé par</u>**

• la production des champs magnétiques à gradient ($G_x$, $G_{y1}$, $G_{y2}$, $G_z$) pendant l'excitation avec un tracé temporel tel que les trajectoires soient limitées à une moitié de l'espace k;
• la réception sensible à la phase du signal RM en résultant et comprenant une partie réelle et une partie imaginaire;
• l'évaluation uniquement de la partie réelle des signaux RM.

**8.** Procédé RM selon la revendication 7,
**<u>caractérisé par</u>**

• la production d'un premier champ à gradient magnétique ($G_x$) pendant l'impulsion à haute fréquence dont le gradient s'étend dans une première direction et dont la polarité change plusieurs fois entre une valeur positive et une valeur négative et par
• la production du deuxième champ magnétique à gradient ($G_{y1}$, $G_{y2}$) dont le gradient évolue dans une deuxième direction pendant le changement de polarité du premier champ à gradient magnétique ($G_x$).

**9.** Appareil RM pour l'exécution du procédé selon la revendication 1
**<u>caractérisé par</u>**

• un émetteur à haute fréquence (12) pour la production d'impulsions magnétiques à haute fréquence;
• un récepteur pour la réception de signaux RM;
• un générateur (4) pour la production de champs magnétiques à gradient ($G_x$, $G_{y1}$, $G_{y2}$, $G_z$) avec des gradients évoluant différemment dans le temps et l'espace;
• une unité d'évaluation (24) pour le traitement des signaux RM reçus et

• une unité de commande (5) commandant l'émetteur à haute fréquence (12), le récepteur, le générateur (4) et l'unité d'évaluation (24) qui est programmée de telle sorte que les étapes suivantes soient exécutées:

• excitation de la magnétisation nucléaire dans une zone d'examen par au moins une impulsion à haute fréquence;

• production d'un champ magnétique à gradient ($G_{y1}$, $G_{y2}$) avec un tracé temporel tel qu'il soit produit au moins deux signaux RM qui correspondent à une excitation dans l'espace k le long de trajectoires décalées parallèlement l'une à l'autre;

• réception et addition des signaux RM.

**10.** Appareil RM pour l'exécution du procédé selon la revendication 7
<u>**caractérisé par**</u>

• un émetteur à haute fréquence (12) pour la production d'impulsions magnétiques à haute fréquence;

• un récepteur pour la réception de signaux RM;

• un générateur (4) pour la production de champs magnétiques à gradient ($G_x$, $G_{y1}$, $G_{y2}$, $G_z$) avec des gradients évoluant différemment dans le temps et l'espace;

• une unité d'évaluation (24) pour le traitement des signaux RM reçus et

• une unité de commande (5) commandant l'émetteur à haute fréquence (12), le récepteur, le générateur (4) et l'unité d'évaluation (24) qui est programmée de telle sorte que les étapes suivantes soient exécutées:

• excitation de la magnétisation nucléaire dans une zone d'examen par au moins une impulsion à haute fréquence;

• production de champs magnétiques à gradient ($G_x$, $G_{y1}$, $G_{y2}$, $G_z$) pendant l'excitation avec un tracé temporel tel que les trajectoires soient limitées à une moitié de l'espace k;

• réception sensible à la phase du signal RM en résultant comprenant une partie réelle et une partie imaginaire;

• évaluation uniquement de la partie réelle des signaux RM.

**11.** Programme informatique pour une unité de commande (5) d'un appareil RM destinée à la commande d'un émetteur à haute fréquence (12), d'un récepteur, d'un générateur (4) et d'une unité d'évaluation (24) en vue de l'exécution du procédé selon la revendication 1 conformément au déroulement suivant:

• excitation de la magnétisation nucléaire dans une zone d'examen par au moins une impulsion à haute fréquence;

• production d'un champ magnétique à gradient ($G_{y1}$, $G_{y2}$) avec un tracé temporel tel qu'il soit produit au moins deux signaux RM qui correspondent à une excitation dans l'espace k le long de trajectoires décalées parallèlement l'une à l'autre;

• réception et addition des signaux RM.

**12.** Programme informatique pour une unité de commande (5) d'un appareil RM destinée à la commande d'un émetteur à haute fréquence (12), d'un récepteur, d'un générateur (4) et d'une unité d'évaluation (24) en vue de l'exécution du procédé selon la revendication 7 conformément au déroulement suivant:

• excitation de la magnétisation nucléaire dans une zone d'examen par au moins une impulsion à haute fréquence;

• production de champs magnétiques à gradient ($G_x$, $G_{y1}$, $G_{y2}$, $G_z$) pendant l'excitation avec un tracé temporel tel que les trajectoires soient limitées à une moitié de l'espace k;

• réception sensible à la phase du signal RM en résultant comprenant une partie réelle et une partie imaginaire;

• évaluation uniquement de la partie réelle des signaux RM.

Fig.1

EP 1 107 015 B1

FIG. 2

FIG. 6

FIG. 3

FIG. 4

$G_z$

$G_{y1}$

## FIG. 5A

$G_z$

$G_{y1}$

## FIG. 5B

$P_{-2}$    $P_{-1}$    $P_{+1}$    $P_{+2}$

$P_{-0}$    MR1

MR2

MR3

MR4

MR+

## FIG. 7

FIG. 8

FIG. 9